# FASCICULE DE BREVET EUROPEEN

(11) **EP 3 177 121 B1**
(45) Date de publication et mention de la délivrance du brevet: **24.03.2021**
(21) Numéro de dépôt: 16201059.9
(22) Date de dépôt: 29.11.2016
(51) Int. Cl.: H05K 5/06, H05K 7/14, H05K 1/14, H05K 3/28

(54) **DISPOSITIF ELECTRIQUE ET PROCEDE D'ASSEMBLAGE D'UN TEL DISPOSITIF ELECTRIQUE**
ELEKTRISCHE VORRICHTUNG UND VERFAHREN ZUM ZUSAMMENBAU EINER SOLCHEN ELEKTRISCHEN VORRICHTUNG
ELECTRIC DEVICE AND METHOD FOR ASSEMBLING SUCH AN ELECTRIC DEVICE

(30) Priorité: 02.12.2015 FR 1561738
(43) Date de publication de la demande: 07.06.2017
(73) Titulaire: Valeo Systemes de Controle Moteur, 95800 Cergy Saint Christophe (FR)
(72) Inventeur: TRAMET, Guillaume, 78360 Montesson (FR); MAS, Arnaud, 95000 Cergy (FR); SACCO, Ernesto, 95000 Cergy (FR)
(74) Mandataire: Novembre, Christophe Adelphe

(56) Documents cités:
- WO-A2-2015/033062
- DE-A1-102007 062 918
- US-A- 5 657 203
- US-A1- 2009 086 455
- US-A1- 2009 103 276
- US-A1- 2015 092 376

## Description

L'invention a pour objet un dispositif électrique destiné à contrôler une machine électrique et un procédé d'assemblage d'un tel dispositif électrique.

Usuellement, un dispositif électrique destiné à contrôler une machine électrique, tel qu'un convertisseur de tension, comprend des unités électroniques qui nécessitent une isolation efficace à la poussière, aux liquides, aux gaz ou encore à l'humidité. Pour cela, une isolation à l'aide d'un dépôt de matériau isolant peut être réalisée.

Cependant, en général, l'isolation d'un dispositif électrique nécessite une quantité importante de matériau isolant afin de garantir une isolation efficace du dispositif électrique. De ce fait, ces dispositifs électriques ont des coûts de production élevés.

Le document US 2009/086455 A1 décrit un dispositif électrique selon le préambule de la revendication 1.

La présente invention vise à remédier à ces inconvénients en proposant un dispositif électrique permettant de réduire la quantité de matériau isolant nécessaire pour isoler le dispositif électrique, tout en garantissant une isolation efficace dudit dispositif électrique.

A cet effet, l'invention a pour objet un dispositif électrique selon la revendication 1.

En particulier, l'électronique de puissance est destinée à délivrer un courant électrique à une machine électrique à partir d'une source de tension.

Avantageusement, dans le dispositif électrique selon l'invention, l'espace entre la première et la deuxième zone permet de diminuer les coûts de production d'un tel dispositif électrique, grâce à une réduction de la quantité de matériau isolant nécessaire pour isoler efficacement les unités électroniques de contrôle et de puissance. En outre, cet espace permet une circulation de l'air entre la première et la deuxième zone et autour de la troisième zone, et ainsi un meilleur refroidissement du dispositif électrique par convection.

Le dispositif électrique selon l'invention peut également comprendre une ou plusieurs des caractéristiques suivantes, considérées individuellement ou selon toutes les combinaisons possibles :
- une seconde extrémité de la colonne creuse opposée à la première extrémité est en contact avec le matériau isolant dans lequel la première unité électronique est noyée ;
- le fond de la cavité ouverte comprend des éléments de guidage du au moins un élément de connexion électrique destinés à guider le au moins un élément de connexion électrique vers la seconde unité électronique, les éléments de guidage étant notamment agencés à la première extrémité de la colonne creuse ;

- le dispositif électrique selon l'invention comprend également un connecteur électrique configuré pour connecter électriquement la première unité électronique à au moins un des éléments électriques (phase ϕ, B⁺, B⁻) d'une machine électrique contrôlée par le dispositif électrique et/ou d'une source d'énergie électrique, et compris au moins en partie dans ledit espace s'étendant autour de la troisième zone et entre la première et la deuxième zone ;
- le connecteur électrique est agencé entre la première unité électronique et le support de la seconde unité électronique, le connecteur électrique comportant un orifice dans lequel la colonne creuse est destinée à être insérée.

L'invention se rapporte également à un procédé d'assemblage d'un dispositif électrique selon la revendication 6.

Autrement dit, une droite passant par la première zone, ledit espace et la deuxième zone, comprend une partie incluse dans la première zone, une partie incluse dans ledit espace et une partie incluse dans la deuxième zone, lesdites parties étant contigües.

En particulier, l'espace est libre de matière, notamment dépourvu de matériau isolant.

En particulier, l'électronique de puissance est destinée à délivrer un courant électrique à une machine électrique à partir d'une source de tension. Par exemple, la machine électrique est un démarreur, un alterno-démarreur ou une autre machine électrique embarquée dans le véhicule

Avantageusement, le procédé d'assemblage du dispositif électrique permet une isolation efficace des unités électroniques, tout en garantissant une réduction des coûts de production, notamment grâce à une réduction de la quantité de matériau nécessaire pour l'isolation du dispositif électrique. En outre, l'espace s'étendant autour de la troisième zone et entre la première et la deuxième zone permet une circulation de l'air entre la première et la deuxième zone et autour de la troisième zone, et ainsi un meilleur refroidissement du dispositif électrique par convection.

Le procédé d'assemblage d'un dispositif électrique selon l'invention peut également comprendre une ou plusieurs des caractéristiques suivantes, considérées individuellement ou selon toutes les combinaisons possibles :
- le procédé d'assemblage d'un dispositif électrique selon l'invention comprend une étape de guidage du au moins un élément de connexion électrique, dans laquelle le au moins un élément de connexion électrique est guidé vers la seconde unité électronique en vue de sa connexion avec la seconde unité électronique par des éléments de guidage agencés à la première extrémité de la colonne creuse ;
- l'étape de dépôt de matériau isolant comprend une étape de remplissage de la colonne creuse, dans laquelle la colonne creuse est remplie de matériau isolant avant de noyer la seconde unité électronique dans le matériau isolant.

D'autres caractéristiques et avantages de la présente invention apparaitront à la lecture de la description et des figures suivantes :
- la figure 1 est une vue éclatée selon un mode de réalisation préféré d'un dispositif électrique selon l'invention,
- la figure 2 représente une vue en coupe d'un dispositif électrique selon le mode de réalisation préféré de la figure 1,
- les figures 3 et 4 représentent une vue en coupe du dispositif électrique de la figure 1 à différentes étapes du procédé d'assemblage dudit dispositif électrique, et
- la figure 5 est un organigramme des étapes du procédé d'assemblage du dispositif électrique selon un mode de réalisation préféré de l'invention.

Il est à noter que ces dessins n'ont d'autre but que d'illustrer le texte de la description et ne constituent en aucune sorte une limitation de la portée de l'invention.

Sur les différentes figures, les éléments analogues sont désignés par des références identiques.

Le dispositif électrique selon l'invention est par exemple destiné à contrôler une machine électrique, notamment une machine électrique destinée à être intégrée dans un véhicule automobile, telle qu'une machine électrique tournante.

Le dispositif électrique comprend au moins une première unité électronique, par exemple une unité électronique de puissance, au moins une seconde unité électronique, par exemple une unité électronique de contrôle, et au moins un élément de connexion électrique destiné à connecter électriquement lesdites unités électroniques.

Le dispositif électrique est par exemple un convertisseur de tension tel qu'illustré sur les figures. Bien entendu, l'invention n'est nullement limitée à un convertisseur de tension, mais au contraire le dispositif électrique pourrait être tout autre dispositif électrique destiné à contrôler une machine électrique.

De même, la première unité électronique sera illustrée par une unité électronique de puissance, telle que un ou plusieurs modules électroniques de puissance et la seconde unité électronique sera illustrée par une unité électronique de contrôle, telle qu'une carte électronique de contrôle. Bien entendu, les unités électroniques pourraient être respectivement tout autre composant électronique.

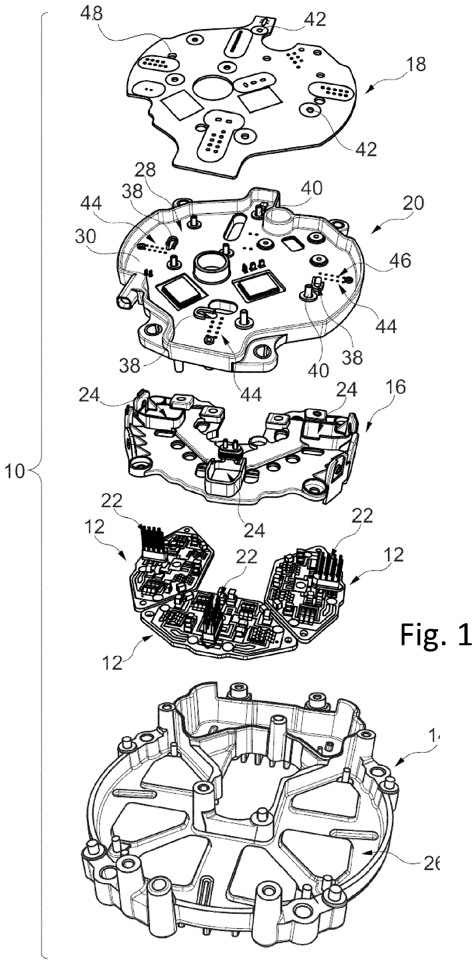

En particulier, la figure 1 représente une vue éclatée d'un convertisseur de tension 10 comprenant des modules électroniques de puissance 12, dans cet exemple au nombre de trois, un support 14 des modules électroniques, un connecteur électrique 16, une carte électronique de contrôle 18, et un support 20 de carte électronique.

Avantageusement, le convertisseur de tension 10 est un convertisseur alternatif-continu. De préférence, le convertisseur de tension 10 est intégré au carter de la machine électrique.

La carte électronique de contrôle 18 est notamment destinée à contrôler les modules électroniques de puissance 12. En particulier, la carte électronique 18 est destinée à être connectée électriquement avec les modules électroniques de puissance 12 via au moins un élément de connexion électrique 22.

Le connecteur électrique 16 est agencé entre les modules électroniques de puissance 12 et le support 20 de la carte électronique. Le connecteur électrique 16 est configuré pour connecter électriquement les modules électroniques 12 à au moins un des éléments électriques (phase ϕ), de la machine électrique et/ou à au moins un des éléments électriques (B⁺, B⁻) d'une source d'énergie électrique. Les éléments électriques de la machine électrique sont, par exemple, des phases ϕ. Les éléments électriques de la source d'énergie électrique sont par exemple une borne continue positive B⁺, une borne continue négative B⁻ ou la masse. Il y a de préférence un module électronique de puissance 12 par phase ϕ. En outre, comme représenté sur la figure 1, le connecteur électrique 16 comprend des orifices 24 agencés pour autoriser l'accès des éléments de connexion électrique 22 des modules électroniques 12 avec la carte électronique de contrôle 18.

Le support 14 de l'unité électronique de puissance est avantageusement un boitier comprenant au moins une cavité ouverte 26 ayant un fond sur lequel les modules électroniques de puissance 12 sont montés. De façon avantageuse, le boitier permet une conduction thermique et électrique, notamment pour la reprise de la masse et la diffusion thermique. La cavité ouverte 26 est destinée à être remplie d'un matériau isolant de sorte que les modules électroniques de puissance 12 sont noyés dans le matériau isolant. En particulier, cette configuration permet une isolation efficace des modules électroniques 12. De façon avantageuse, le support 14 de module puissance est un dissipateur de chaleur, aussi nommé dissipateur thermique. Les modules de puissance 12 sont fixés au dissipateur thermique afin de permettre le transfert thermique entre les modules de puissance 12 et un circuit de refroidissement (non représenté), afin de dissiper la chaleur générée par les modules électroniques 12. En outre, la cavité ouverte 26 de réception des modules électroniques peut comprendre des éléments de positionnement (non représentés) destinés à positionner les modules électroniques 12 sur le support 14 dans une position prédéterminée. Ces éléments de positionnement permettent de faciliter et garantir un positionnement correct et rapide des modules électroniques 12 sur le support 14 en vue de leur connexion électrique avec la carte électronique 18.

Le support 20 de la carte électronique de contrôle est agencé entre les modules électroniques de puissance 12 et la carte électronique de contrôle 18. Le support 20 de la carte électronique de contrôle est de préférence en matière isolante, par exemple moulé en matière plastique.

Le support 20 comprend une cavité ouverte 28 ayant un fond 30 sur lequel la carte électronique 18 est destinée à être reçue.

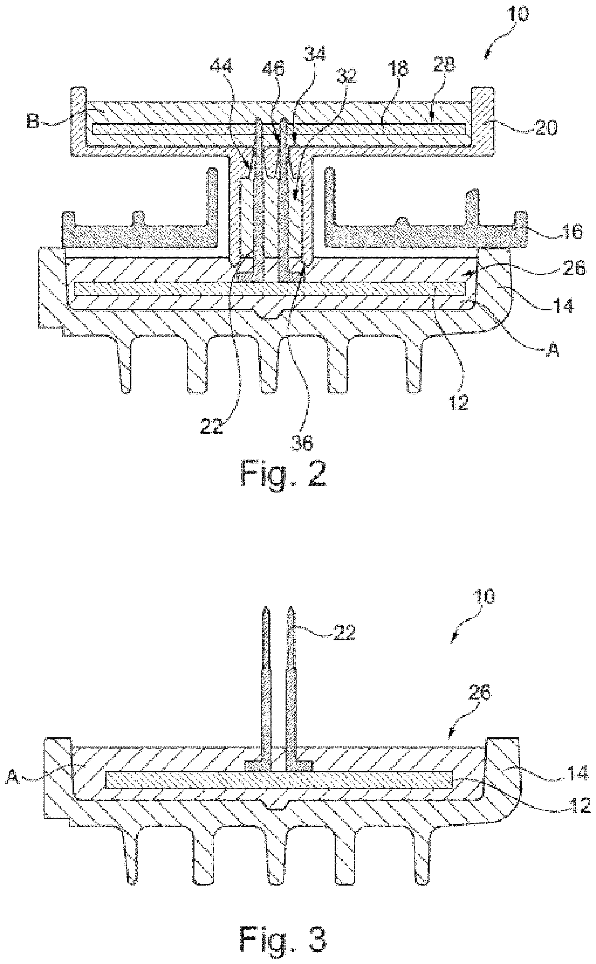

Le support 20 comprend également au moins une colonne creuse 32 dans laquelle le au moins un élément de connexion électrique 22 de la carte électronique 18 avec les modules électroniques 12 est destiné à être inséré. La colonne creuse 32, notamment visible sur la figure 2, s'étend depuis la cavité ouverte 28 et est configurée pour communiquer avec la cavité ouverte 28 à une première extrémité 34 de la colonne creuse 32. En particulier, sur la figure 1, le support 20 de la carte électronique 18 comprend trois colonnes creuses, chaque colonne creuse étant destinée à recevoir les éléments de connexion électrique 22 de chaque module électronique 12 avec la carte électronique de contrôle 18. La cavité ouverte 28 est destinée à être remplie d'un matériau isolant de sorte que la carte électronique de contrôle 18 est noyée dans le matériau isolant. La carte électronique de contrôle 18 est ainsi isolée de manière efficace.

Avantageusement, le support 20 de carte électronique de contrôle peut comprendre un élément de remplissage 38 de la colonne creuse 32. L'élément de remplissage 38, également appelé canal de remplissage, peut avoir une forme générale de rampe, préférentiellement une forme hélicoïdale. Une extrémité de l'élément de remplissage 38 communique avec le fond 30 de la cavité ouverte 28 et une autre extrémité de l'élément de remplissage 38 communique avec une paroi latérale de la colonne creuse 32. De préférence, une seconde extrémité 36 de la colonne creuse 32 est en contact avec le matériau isolant dans lequel le module électronique 12 est noyé. Cette configuration permet de garantir le remplissage de la colonne creuse 32 de matériau isolant, et ainsi d'assurer une isolation efficace des éléments de connexion électrique 22.

La carte électronique de contrôle 18 peut comprendre avantageusement un orifice 48 agencé en vis-à-vis de l'extrémité du canal 38 communiquant avec le fond 30 de la cavité ouverte 28. L'orifice 48 de la carte électronique 18 permet notamment le remplissage de la colonne creuse 32 de matériau isolant B par l'intermédiaire du canal 38.

En outre, le fond 30 de la cavité ouverte 28 comprend de préférence des éléments de positionnement 40 destinés à positionner la carte électronique 18 sur le support 20 dans une position prédéterminée. Autrement dit, les éléments de positionnement 40 disposés sur le support 20 de la carte électronique sont destinés à coopérer avec des éléments de positionnement complémentaires 42 de la carte électronique 18. Par exemple, sur la figure 1, six éléments de positionnement 40 sont représentés, comprenant chacun un ergot faisant saillie depuis le fond 30 de la cavité ouverte 28, de façon perpendiculaire au fond 30. Les éléments de positionnement 40 peuvent être de forme cylindrique comme représenté sur la figure 1. Les six éléments de positionnement complémentaires 42 de la carte électronique sont des orifices de positionnement présentant de préférence une section de forme et de dimensions complémentaires à la forme et aux dimensions des éléments de positionnement 40. Par exemple, comme illustré sur la figure 1, les éléments de positionnement complémentaires 42 présentent une section circulaire. Ces éléments de positionnement 40 permettent de positionner correctement et rapidement la carte électronique 18 sur le support 20, et ainsi de permettre une connexion électrique efficace de la carte électronique 18 avec les modules électroniques de puissance 12.

De plus, le fond 30 de la cavité ouverte 28 comprend avantageusement des éléments de guidage 44 du au moins un élément de connexion électrique 22 agencés à la première extrémité 34 de la colonne creuse 32 et destinés à guider le au moins un élément de connexion électrique 22 vers la carte électronique 18. Par exemple, sur la figure 1, le fond 30 de la cavité ouverte 28 comprend trois groupes d'éléments de guidage 44. Les éléments de guidage 44 comprennent des orifices de guidage 46, avantageusement un orifice de guidage 46 par élément de connexion électrique 22. Les orifices de guidage 46 permettent de recentrer les éléments de connexion électrique 22 en vue de la connexion électrique du module électronique 12 avec la carte électronique 18 et ainsi de connecter correctement le module électronique 12 avec la carte électronique 18. De préférence, afin de permettre un meilleur recentrage des éléments de connexion électrique 22, la section des orifices de guidage 46 en regard du module électronique 12 est plus grande que la section des orifices de guidage 46 en regard de la carte électronique 18. Par exemple, sur la figure 2, les deux éléments de guidage 44 présentent une section circulaire et comportent une portion tronconique suivie d'une portion cylindrique.

De plus, le dispositif électrique 10 est destiné à recevoir des matériaux isolants A, B permettant une isolation de l'unité électronique de puissance 12, de l'unité électronique de contrôle 18 et des éléments de connexion électrique 22. Les matériaux isolants A, B permettent une isolation à la poussière, aux liquides, aux gaz ou encore à l'humidité.

Par exemple, le matériau isolant peut être une résine, telle qu'une résine époxy, ou un gel isolant, tel qu'un gel de silicone.

Les unités électroniques 12, 18 du dispositif électrique 10 peuvent être isolées avec des matériaux isolants A, B identiques ou différents. De préférence les unités électroniques de contrôle et de puissance sont isolées avec un matériau isolant identique, notamment avec un gel isolant.

Plus précisément, le dispositif électrique comprend :
- une première zone remplie d'un matériau isolant A et comprenant une unité électronique de puissance 12 noyée dans le matériau isolant ;
- une deuxième zone remplie d'un matériau isolant B et comprenant une unité électronique de contrôle 18 noyée dans le matériau isolant B ; et
- une troisième zone remplie d'un matériau isolant B et comprenant au moins un élément de connexion électrique 22 noyé dans le matériau isolant B.

La première et la deuxième zone sont chacune en contact avec la troisième zone de sorte que le dispositif électrique 10 comprend au moins un espace s'étendant autour de la troisième zone et entre la première et la deuxième zone.

Plus précisément, comme représenté sur la figure 2, la cavité ouverte 26 du support 14 des modules électroniques de puissance est remplie d'une couche de matériau isolant A de manière à définir la première zone. La cavité ouverte 28 du support 20 de la carte électronique 18 est remplie d'une couche de matériau isolant B de manière à définir la deuxième zone. La colonne creuse 32 est remplie, notamment majoritairement remplie, de matériau isolant B de manière à définir la troisième zone. L'interface entre les matériaux isolants A et B est notamment située à l'intérieur de la colonne creuse 32, à proximité de la seconde extrémité 36 de la colonne creuse 32. Ici, les matériaux isolants A et B sont les mêmes gels isolants.

Autrement dit, le matériau isolant A, B emplit l'espace intérieur libre de chaque cavité ouverte 26, 28 autour des composants de la carte électronique 18 et/ou des modules électroniques de puissance 12. Le matériau isolant A, B permet l'étanchéité de la carte électronique 18 et des modules électroniques de puissance 12, notamment l'étanchéité à la poussière et aux liquides. Le matériau isolant permet ainsi de supprimer tout risque de court-circuit possible au niveau de la carte électronique 18 ou des modules de puissance 12.

De plus, comme représenté sur la figure 2, la seconde extrémité 36 de la colonne creuse 32 opposée à la première extrémité 34 est en contact avec le matériau isolant A dans lequel le module électronique de puissance 12 est noyé de sorte que les éléments de connexion électrique 22 sont noyés dans les matériaux isolants A, B. Cette configuration permet de supprimer tout risque de court-circuit possible au niveau de l'interconnexion de la carte électronique 18 avec les modules de puissance 12.

En outre, l'espace compris entre la carte électronique 18 et le module de puissance 12 et entourant la colonne creuse 32 est dépourvu de matière, notamment de matériau isolant. L'espace libre de matière, notamment de matériau isolant, entre la première et la deuxième zone a, entre autres, pour effet de laisser un espace libre pour la circulation d'air, permettant ainsi un refroidissement par convection. De plus, cette configuration permet de diminuer les coûts de production du dispositif électrique 10, grâce notamment à un gain en matériau isolant.

De plus, l'invention concerne également un procédé d'assemblage d'un tel dispositif électrique selon l'invention. Différentes étapes du procédé d'assemblage sont illustrées sur les figures 3 à 5 et vont être décrites plus en détail dans la suite de la description.

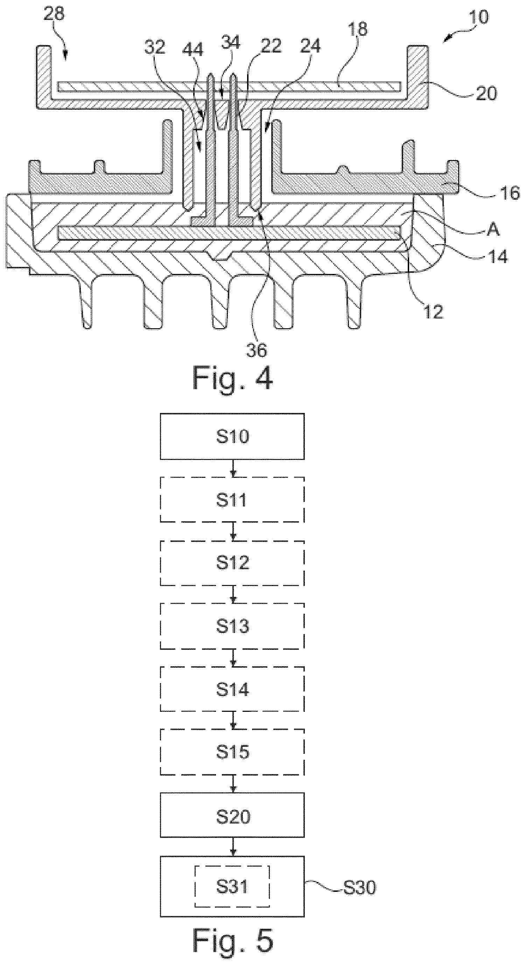

En regard de la figure 5, le procédé d'assemblage du dispositif électrique comprend une étape S10 dans laquelle une unité électronique de contrôle 18, une unité électronique de puissance 12 noyée dans un matériau isolant A formant une première zone et au moins un élément de connexion électrique 22 dont une extrémité est connectée à ladite unité électronique de puissance 12 sont fournis.

Par exemple et de préférence, le procédé d'assemblage du dispositif électrique comprend une étape S11 dans laquelle un support 14 de l'unité électronique de puissance, ici un module électronique de puissance 12 est fourni. Comme représenté sur la figure 3, la cavité ouverte 26 du support 14 est destinée à recevoir un module électronique de puissance 12 et à être rempli de matériau isolant A, de sorte que l'unité électronique de puissance 12 est noyée dans le matériau isolant A.

Avantageusement, le procédé d'assemblage du dispositif électrique peut comprendre une étape S12 dans laquelle un connecteur électrique 16 est fourni. L'agencement du connecteur électrique 16 vis-à-vis d'un module électronique 12 et du support 14 de module électronique est par exemple visible sur la figure 4. Le connecteur électrique 16 est compris au moins en partie dans l'espace s'étendant autour de la troisième zone et entre la première et la deuxième zone. Le connecteur électrique 16 comprend un orifice 24 agencé pour autoriser l'accès des éléments de connexion électrique 22 des modules électroniques 12 avec la carte électronique de contrôle 18.

Selon un mode de réalisation préféré illustré en figure 5, le procédé d'assemblage du dispositif électrique comprend de préférence une étape S13 dans laquelle un support 20 de l'unité électronique de contrôle 18 tel que décrit précédemment est fourni. Le support 20 de l'unité électronique de contrôle est alors agencé entre l'unité électronique de puissance 12 et l'unité électronique de contrôle 18. Comme représenté sur la figure 4, le support 20 de carte électronique est fixé dans le support 14 de modules électroniques de sorte à être en vis-à-vis des modules électroniques de puissance 12. Le support 20 comprend de préférence une cavité ouverte 28 destinée à recevoir l'unité électronique de contrôle 18 et une colonne creuse 32 telles que décrites précédemment.

Ainsi, les première, deuxième et troisième zones sont superposées, les première et deuxième zones s'étendant sensiblement suivant des plans parallèles.

Suite à l'étape S13, le procédé d'assemblage peut comprendre une étape S14 d'insertion du au moins un élément de connexion électrique 22 dans la colonne creuse 32. Comme représenté sur la figure 4, les éléments de connexion électrique 22 sont alors insérés dans la colonne creuse 32 en vue de leur connexion avec l'unité électronique de contrôle 18. La seconde extrémité 36 de la colonne creuse 32 opposée à la première extrémité 34 est en contact avec le matériau isolant A dans lequel l'unité électronique de puissance 12 est noyée. Cette configuration permet de supprimer tout risque de court-circuit possible au niveau de l'interconnexion de la carte électronique 18 avec les modules de puissance 12, la colonne creuse 32 étant destinée à être remplie de matériau isolant B.

De manière avantageuse, le procédé d'assemblage du dispositif électrique peut comprendre une étape S15 de guidage du au moins un élément de connexion électrique 22. Le support 20 de carte électronique comprend des éléments de guidage 44 des éléments de connexion électrique 22 tels que représentés sur la figure 4. Les éléments de connexion électrique sont guidés vers l'unité électronique de contrôle 18 par les éléments de guidage 44 agencés à la première extrémité 34 de la colonne creuse 32.

Le procédé d'assemblage du dispositif électrique selon l'invention comprend en outre une étape S20 de connexion du au moins un élément de connexion électrique 22. Comme représenté sur la figure 4, une extrémité des éléments de connexion électrique 22 est connectée au module électronique 12 et l'extrémité opposée à l'extrémité connectée audit module électronique de puissance 12 est connectée à la carte électronique de contrôle 18.

Suite à l'étape S20, le procédé d'assemblage du dispositif électrique selon l'invention comprend une étape S30 de dépôt d'un matériau isolant. Comme illustré sur la figure 2, le module électronique 12 est noyé dans une couche de matériau isolant A tandis que la carte électronique 18 et les éléments de connexion électrique 22 sont noyés dans une couche de matériau isolant B. Une zone dépourvue de matériau isolant est visible, autour des éléments de connexion électrique 22 et entre le support 20 de la carte électronique de contrôle et le matériau isolant A recouvrant le module électronique de puissance 12. Cette zone dépourvue de matériau isolant permet un refroidissement efficace des modules électroniques, tout en garantissant une isolation au niveau des éléments de connexion électrique 22.

D'autre part, l'étape S30 peut comprendre une étape S31 de remplissage de la colonne creuse 32, dans laquelle la colonne creuse 32 est remplie de matériau isolant B avant de noyer l'unité électronique de contrôle 18 dans le matériau isolant B. Le dépôt de matériau isolant B à l'intérieur de la colonne creuse 32 est effectué par l'élément de remplissage 38 du support 20 de carte électronique. Le remplissage de la colonne creuse 32 par l'élément de remplissage 38 permet de remplir entièrement la colonne creuse 32. Cela permet une meilleure isolation des éléments de connexion électrique 22 et d'éviter d'éventuels risques de court-circuit au niveau de l'interconnexion du module électronique 12 avec la carte électronique 18.

Comme illustré sur la figure 6, selon un mode de réalisation préféré de l'invention, les étapes S11 à S15 peuvent être réalisées consécutivement et en combinaison avant l'étape S20. Bien entendu, ce mode de réalisation n'est pas limitatif, les étapes S11 à S15 peuvent être réalisées consécutivement ou non, seules ou selon toute combinaison possible.

Le dispositif électrique destiné à contrôler une machine électrique a été décrit dans le cadre d'un convertisseur de tension destiné à alimenter une machine électrique notamment destinée à alimenter un véhicule automobile. Bien entendu, d'autres applications du dispositif électrique conforme à l'invention sont également possibles sans sortir du cadre de l'invention.

## Revendications

1. Dispositif électrique (10), notamment destiné à contrôler une machine électrique, comprenant :
- une première zone remplie d'un matériau isolant (A) et comprenant une première unité électronique (12) noyée dans le matériau isolant (A) ;
- une deuxième zone remplie d'un matériau isolant (B) et comprenant une seconde unité électronique (18) noyée dans le matériau isolant (B) ; et
- une troisième zone remplie d'un matériau isolant (B) et comprenant au moins un élément de connexion électrique (22) noyé dans le matériau isolant (B), le au moins un élément de connexion électrique (22) connectant la première unité électronique (12) avec la seconde unité électronique (18) ;
dans lequel la première et la deuxième zone sont chacune en contact avec la troisième zone de sorte que le dispositif électrique (10) comprend au moins un espace s'étendant autour de la troisième zone et entre la première et la deuxième zone, ledit espace étant libre de matière, notamment dépourvu de matériau isolant,
et dans lequel, les première, deuxième et troisième zones sont superposées, les première et deuxième zones s'étendant sensiblement suivant des plans parallèles, ledit dispositif électrique comprenant également un support (20) d'une unité électronique agencé entre la première unité électronique (12) et la seconde unité électronique (18) et comprenant une cavité ouverte (28) destinée à recevoir la seconde unité électronique (18),
ledit dispositif électrique étant **caractérisé en ce que**
la troisième zone est définie au moins en partie par une colonne creuse (32) dans laquelle le au moins un élément de connexion électrique (22) est destiné à être inséré, la colonne creuse (32) s'étendant entre la première et la deuxième zone, la colonne creuse (32) étant remplie de matériau isolant (B), la colonne creuse (32) s'étendant depuis la cavité ouverte (28) et étant configurée pour communiquer avec la cavité ouverte (28) à une première extrémité (34) de la colonne creuse (32).

2. Dispositif électrique selon la revendication 1, dans lequel une seconde extrémité (36) de la colonne creuse (32) opposée à la première extrémité (34) est en contact avec le matériau isolant (A) dans lequel la première unité électronique (12) est noyée.

3. Dispositif électrique selon l'une quelconque des revendications 1 à 2, dans lequel le fond (30) de la cavité ouverte (28) comprend des éléments de guidage (44) du au moins un élément de connexion électrique (22) destinés à guider le au moins un élément de connexion électrique (22) vers la seconde unité électronique (18).

4. Dispositif électrique selon l'une quelconque des revendications 1 à 3, comprenant également un connecteur électrique (16) configuré pour connecter électriquement la première unité électronique (12) à au moins un des éléments électriques (phase ϕ, B⁺, B⁻) d'une machine électrique contrôlée par le dispositif électrique et/ou d'une source d'énergie électrique, et compris au moins en partie dans ledit espace s'étendant autour de la troisième zone et entre la première et la deuxième zone.

5. Dispositif électrique selon les revendications 1 et 4, dans lequel le connecteur électrique (16) est agencé entre la première unité électronique (12) et le support (20) de la seconde unité électronique, le connecteur électrique (16) comportant un orifice (24) dans lequel la colonne creuse (32) est destinée à être insérée.

6. Procédé d'assemblage d'un dispositif électrique (10), notamment destiné à contrôler une machine électrique, comprenant :
- une étape (S10) dans laquelle une première unité électronique (12) noyée dans un matériau isolant (A) formant une première zone, une seconde unité électronique (18) et au moins un élément de connexion électrique (22) dont une extrémité est connectée à ladite première unité électronique (12) sont fournis ;
- une étape (S20) de connexion du au moins un élément de connexion électrique (22), dans laquelle une extrémité opposée à l'extrémité connectée à ladite première unité électronique (12) est connectée à la seconde unité électronique (18) ; et
- une étape (S30) de dépôt d'un matériau isolant (B), dans laquelle la seconde unité électronique (18) est noyée dans un matériau isolant (B) formant une deuxième zone et le au moins un élément de connexion électrique (22) est noyé dans un matériau isolant (B) formant une troisième zone de sorte que la première et la deuxième zone sont chacune en contact avec la troisième zone et que le dispositif électrique (10) comprend au moins un espace s'étendant autour de la troisième zone et entre la première et la deuxième zone,
ledit procédé comprenant en outre avant l'étape de connexion du au moins un élément de connexion électrique (34) :
- une étape (S13) dans laquelle un support (20) d'une unité électronique est fourni, le support (20) de l'unité électronique étant agencé entre la première unité électronique (12) et la seconde unité électronique (18), et comprenant une cavité ouverte (28) destinée à recevoir la seconde unité électronique (18), et une colonne creuse (32) s'étendant depuis la cavité ouverte (28), et communiquant avec la cavité ouverte (28) à une première extrémité (34) de la colonne creuse (32) ;
- une étape (S14) d'insertion du au moins un élément de connexion électrique (22) dans la colonne creuse (32), dans laquelle le au moins un élément de connexion électrique (22) est inséré dans la colonne creuse (32) en vue de sa connexion avec la seconde unité électronique (18), de sorte qu'une seconde extrémité (36) de la colonne creuse (22) opposée à la première extrémité (34) est en contact avec le matériau isolant (A) dans lequel la première unité électronique (12) est noyée

7. Procédé d'assemblage d'un dispositif électrique selon la revendication 6, comprenant une étape (S15) de guidage du au moins un élément de connexion électrique (22), dans laquelle le au moins un élément de connexion électrique (22) est guidé vers la seconde unité électronique (18) en vue de sa connexion avec la seconde unité électronique (18) par des éléments de guidage (44) agencés à la première extrémité (34) de la colonne creuse (32).

8. Procédé d'assemblage d'un dispositif électrique selon la revendication 6 ou 7, dans lequel l'étape (S30) de dépôt de matériau isolant (B) comprend une étape (S31) de remplissage de la colonne creuse (32), dans laquelle la colonne creuse (32) est remplie de matériau isolant (B) avant de noyer la seconde unité électronique (18) dans le matériau isolant (B).

## Patentansprüche

1. Elektrische Vorrichtung (10), insbesondere dazu bestimmt, eine elektrische Maschine zu steuern, die enthält:
- einen ersten Bereich, der mit einem Isoliermaterial (A) gefüllt ist und eine in das Isoliermaterial (A) eingebettete erste elektronische Einheit (12) enthält;
- einen zweiten Bereich, der mit einem Isoliermaterial (B) gefüllt ist und eine in das Isoliermaterial (B) eingebettete zweite elektronische Einheit (18) enthält; und
- einen dritten Bereich, der mit einem Isoliermaterial (B) gefüllt ist und mindestens ein in das Isoliermaterial (B) eingebettetes elektrisches Verbindungselement (22) enthält, wobei das mindestens eine elektrische Verbindungselement (22) die erste elektronische Einheit (12) mit der zweiten elektronischen Einheit (18) verbindet;
wobei der erste und der zweite Bereich je mit dem dritten Bereich in Kontakt sind, so dass die elektrische Vorrichtung (10) mindestens einen Raum enthält, der sich um den dritten Bereich und zwischen dem ersten und dem zweiten Bereich erstreckt, wobei der Raum frei von Material ist, insbesondere kein Isoliermaterial enthält, und wobei der erste, zweite und dritte Bereich übereinander angeordnet sind, wobei der erste und der zweite Bereich sich im Wesentlichen gemäß parallelen Ebenen erstrecken,
wobei die elektrische Vorrichtung ebenfalls einen Träger (20) einer elektronischen Einheit enthält, der zwischen der ersten elektronischen Einheit (12) und der zweiten elektronischen Einheit (18) angeordnet ist und einen offenen Hohlraum (28) enthält, der dazu bestimmt ist, die zweite elektronische Einheit (18) aufzunehmen,
wobei die elektrische Vorrichtung **dadurch gekennzeichnet ist, dass**
der dritte Bereich zumindest zum Teil von einer Hohlsäule (32) definiert wird, in die das mindestens eine elektrische Verbindungselement (22) eingeführt werden soll, wobei die Hohlsäule (32) sich zwischen dem ersten und dem zweiten Bereich erstreckt, wobei die Hohlsäule (32) mit Isoliermaterial (B) gefüllt ist, wobei die Hohlsäule (32) sich vom offenen Hohlraum (28) aus erstreckt und konfiguriert ist, mit dem offenen Hohlraum (28) an einem ersten Ende (34) der Hohlsäule (32) in Verbindung zu stehen.

2. Elektrische Vorrichtung nach Anspruch 1, wobei ein zweites Ende (36) der Hohlsäule (32) entgegengesetzt zum ersten Ende (34) mit dem Isoliermaterial (A) in Kontakt ist, in das die erste elektronische Einheit (12) eingebettet ist.

3. Elektrische Vorrichtung nach einem der Ansprüche 1 bis 2, wobei der Boden (30) des offenen Hohlraums (28) Führungselemente (44) des mindestens einen elektrischen Verbindungselements (22) enthält, die dazu bestimmt sind, das mindestens eine elektrische Verbindungselement (22) zur zweiten elektronischen Einheit (18) zu führen.

4. Elektrische Vorrichtung nach einem der Ansprüche 1 bis 3, die ebenfalls einen elektrischen Verbinder (16) enthält, der konfiguriert ist, die erste elektronische Einheit (12) mit mindestens einem der elektrischen Elemente (Phase ϕ, B⁺, B⁻) einer von der elektrische Vorrichtung gesteuerten elektrischen Maschine und/oder einer Quelle elektrischer Energie zu verbinden, und zumindest zum Teil in dem Raum enthalten ist, der sich um den dritten Bereich herum und zwischen dem ersten und dem zweiten Bereich erstreckt.

5. Elektrische Vorrichtung nach den Ansprüchen 1 und 4, wobei der elektrische Verbinder (16) zwischen der ersten elektronischen Einheit (12) und dem Träger (20) der zweiten elektronischen Einheit angeordnet ist, wobei der elektrische Verbinder (16) eine Öffnung (24) aufweist, in die die Hohlsäule (32) eingeführt werden soll.

6. Verfahren zum Zusammenbau einer elektrischen Vorrichtung (10), die insbesondere dazu bestimmt ist, eine elektrische Maschine zu steuern, das enthält:
- einen Schritt (S10), in dem eine erste elektronische Einheit (12), die in ein Isoliermaterial (A) eingebettet ist, das einen ersten Bereich bildet, eine zweite elektronische Einheit (18) und mindestens ein elektrisches Verbindungselement (22), von dem ein Ende mit der ersten elektronischen Einheit (12) verbunden ist, bereitgestellt werden;
- einen Schritt (S20) der Verbindung des mindestens einen elektrischen Verbindungselements (22), in dem ein Ende entgegengesetzt zu dem mit der ersten elektronischen Einheit (12) verbundenen Ende mit der zweiten elektronischen Einheit (18) verbunden wird; und
- einen Schritt (S30) des Aufbringens eines Isoliermaterials (B), in dem die zweite elektronische Einheit (18) in ein Isoliermaterial (B) eingebettet wird, das einen zweiten Bereich bildet, und das mindestens eine elektrische Verbindungselement (22) in ein Isoliermaterial (B) eingebettet wird, das einen dritten Bereich bildet, so dass der erste und der zweite Bereich je mit dem dritten Bereich in Kontakt sind, und dass die elektrische Vorrichtung (10) mindestens einen Raum enthält, der sich um den dritten Bereich herum und zwischen dem ersten und dem zweiten Bereich erstreckt,
wobei das Verfahren außerdem vor dem Verbindungsschritt des mindestens einen elektrischen Verbindungselements (34) enthält:
- einen Schritt (S13), in dem ein Träger (20) einer elektronischen Einheit bereitgestellt wird, wobei der Träger (20) der elektronischen Einheit zwischen der ersten elektronischen Einheit (12) und der zweiten elektronischen Einheit (18) angeordnet ist, und einen offenen Hohlraum (28), der dazu bestimmt ist, die zweite elektronische Einheit (18) aufzunehmen, und eine Hohlsäule (32) enthält, die sich vom offenen Hohlraum (28) aus erstreckt und mit dem offenen Hohlraum (28) an einem ersten Ende (34) der Hohlsäule (32) in Verbindung steht;
- einen Schritt (S14) des Einführens des mindestens einen elektrischen Verbindungselements (22) in die Hohlsäule (32), in dem das mindestens eine elektrische Verbindungselement (22) für seine Verbindung mit der zweiten elektronischen Einheit (18) in die Hohlsäule (32) eingeführt wird, so dass ein zweites Ende (36) der Hohlsäule (22) entgegengesetzt zum ersten Ende (34) mit dem Isoliermaterial (A) in Kontakt ist, in das die erste elektronische Einheit (12) eingebettet ist.

7. Verfahren zum Zusammenbau einer elektrischen Vorrichtung nach Anspruch 6, das einen Schritt (S15) der Führung des mindestens einen elektrischen Verbindungselements (22) enthält, in dem das mindestens eine elektrische Verbindungselement (22) für seine Verbindung mit der zweiten elektronischen Einheit (18) durch am ersten Ende (34) der Hohlsäule (32) angeordnete Führungselemente (44) zur zweiten elektronischen Einheit (18) geführt wird.

8. Verfahren zum Zusammenbau einer elektrischen Vorrichtung nach Anspruch 6 oder 7, wobei der Schritt (S30) des Aufbringens von Isoliermaterial (B) einen Schritt (S31) des Füllens der Hohlsäule (32) enthält, in dem die Hohlsäule (32) mit Isoliermaterial (B) gefüllt wird, ehe die zweite elektronische Einheit (18) in das Isoliermaterial (B) eingebettet wird.

## Claims

1. Electrical device (10), particularly intended for controlling an electrical machine, comprising:
- a first region filled with an insulating material (A) and comprising a first electronic unit (12) embedded in the insulating material (A);
- a second region filled with an insulating material (B) and comprising a second electronic unit (18) embedded in the insulating material (B); and
- a third region filled with an insulating material (B) and comprising at least one electrical connection element (22) embedded in the insulating material (B), the at least one electrical connection element (22) connecting the first electronic unit (12) to the second electronic unit (18) ;
wherein the first and the second region are each in contact with the third region such that the electrical device (10) comprises at least one space extending around the third region and between the first and the second region, said space being free of material, in particular devoid of insulating material,
and wherein the first, second and third regions are superposed, the first and second regions extending substantially in parallel planes,
said electrical device also comprising a support (20) for an electronic unit arranged between the first electronic unit (12) and the second electronic unit (18) and comprising an open cavity (28) intended to receive the second electronic unit (18), said electrical device being **characterized in that** the third region is defined at least in part by a hollow column (32) in which the at least one electrical connection element (22) is intended to be inserted, the hollow column (32) extending between the first and the second region, the hollow column (32) being filled with insulating material (B), the hollow column (32) extending from the open cavity (28) and being configured to communicate with the open cavity (28) at a first end (34) of the hollow column (32).

2. Electrical device according to Claim 1, wherein a second end (36) of the hollow column (32) opposite the first end (34) is in contact with the insulating material (A) in which the first electronic unit (12) is embedded.

3. Electrical device according to either one of Claims 1 and 2, wherein the bottom (30) of the open cavity (28) comprises guide elements (44) for the at least one electrical connection element (22) that are intended to guide the at least one electrical connection element (22) towards the second electronic unit (18).

4. Electrical device according to any one of Claims 1 to 3, also comprising an electrical connector (16) configured to electrically connect the first electronic unit (12) to at least one of the electrical elements (phase ϕ, B⁺, B⁻) of an electrical machine controlled by the electrical device and/or of an electrical energy source, and contained at least in part in said space extending around the third region and between the first and the second region.

5. Electrical device according to Claims 1 and 4, wherein the electrical connector (16) is arranged between the first electronic unit (12) and the support (20) for the second electronic unit, the electrical connector (16) comprising an orifice (24) in which the hollow column (32) is intended to be inserted.

6. Method for assembling an electrical device (10), particularly intended for controlling an electrical machine, comprising:
- a step (S10) in which a first electronic unit (12) embedded in an insulating material (A) forming a first region, a second electronic unit (18) and at least one electrical connection element (22) having one end connected to said first electronic unit (12) are provided;
- a step (S20) of connecting the at least one electrical connection element (22), in which an end opposite the end connected to said first electronic unit (12) is connected to the second electronic unit (18); and
- a step (S30) of depositing an insulating material (B), in which step the second electronic unit (18) is embedded in an insulating material (B) forming a second region and the at least one electrical connection element (22) is embedded in an insulating material (B) forming a third region such that the first and the second region are each in contact with the third region and such that the electrical device (10) comprises at least one space extending around the third region and between the first and the second region,
said method additionally comprising, before the step of connecting the at least one electrical connection element (34):
- a step (S13) in which a support (20) for an electrical unit is provided, the support (20) for the electronic unit being arranged between the first electronic unit (12) and the second electronic unit (18) and comprising an open cavity (28) intended to receive the second electronic unit (18), and a hollow column (32) extending from the open cavity (28), and communicating with the open cavity (28) at a first end (34) of the hollow column (32);
- a step (S14) of inserting the at least one electrical connection element (22) into the hollow column (32), in which the at least one electrical connection element (22) is inserted into the hollow column (32) in order to connect it to the second electronic unit (18), with the result that a second end (36) of the hollow column (22) opposite the first end (34) is in contact with the insulating material (A) in which the first electronic unit (12) is embedded.

7. Method of assembling an electrical device according to Claim 6, comprising a step (S15) of guiding the at least one electrical connection element (22), in which step the at least one electrical connection element (22) is guided towards the second electronic unit (18) in order to connect it to the second electronic unit (18) by way of guide elements (44) arranged at the first end (34) of the hollow column (32) .

8. Method of assembling an electrical device according to Claim 6 or 7, wherein the step (S30) of depositing insulating material (B) comprises a step (S31) of filling the hollow column (32), in which step the hollow column (32) is filled with insulating material (B) before embedding the second electronic unit (18) in the insulating material (B).
